# EUROPEAN PATENT APPLICATION

(11) **EP 1 610 185 A2**
(43) Date of publication of application: **28.12.2005**
(21) Application number: 05012644.0
(22) Date of filing: 13.06.2005
(51) Int. Cl.: G03F 7/42

(54) **Composition and method using same for removing residue from a substrate**

(30) Priority: 15.06.2004 US 580001 P; 02.06.2005 US 142450
(71) Applicant: AIR PRODUCTS AND CHEMICALS, INC., Allentown, PA 18195-1501 (US)
(72) Inventor: Hsu, Jiun Yi, Bethlehem, PA 18020 (US); Wu, Aiping, Macungie, PA 18062 (US); Egbe, Matthew I., West Norriton, PA 19403 (US)
(74) Representative: Schwabe - Sandmair - Marx

(57) **Abstract**

A composition for removing residues and method using same are described herein. In one aspect, the composition comprises: an organic polar solvent; water; a quaternary ammonium compound; and a mercapto-containing corrosion inhibitor selected from a compound having the following formulas (I), (II), 2-mercaptothiazoline, 3-mercaptopropyl-trimethoxysilane, and mixtures thereof: 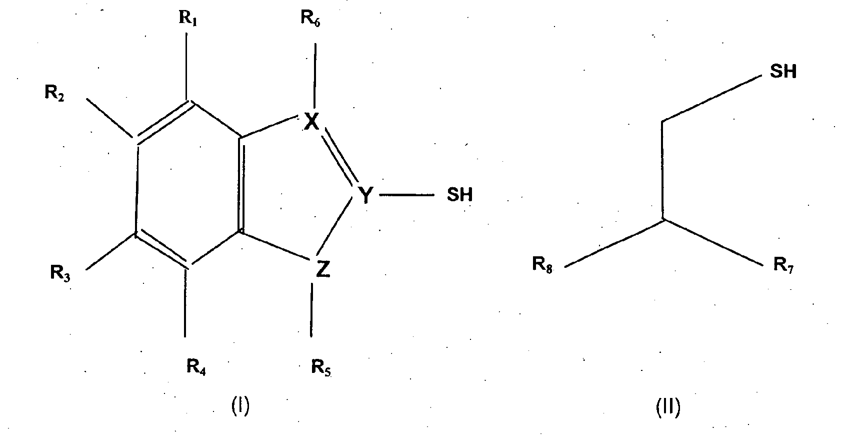 wherein X, Y, and Z are each independently selected from C, N, O, S, and P; R₁, R₂, R₃, R₄, R₅, and R₆ are each independently an alkyl group having a formula CₙH₂ₙ₊₁; R₇ is one selected from H, -OH, -COOH, and -NH₂; and R₈ is selected from an alkyl group having a formula CₙH₂ₙ₊₁, or an alkanol group having a formula CₙH₂ₙOH; n ranges from 0 to 20; and the composition is substantially free of a water soluble amine. In another aspect, the composition comprises hydroxylamine wherein the mass ratio of hydroxylamine to quarternary ammonium compound is less than 3.

## Description

### CROSS-REFERENCE TO RELATED APPLICATIONS

This application claims the benefit of U.S. Provisional Application No. 60/580,001, filed 15 June 2004.

### BACKGROUND OF THE INVENTION

Numerous steps are involved in the fabrication of microelectronic structures. Within the manufacturing scheme of fabricating integrated circuits, selective etching of semiconductor surfaces is sometimes required. Historically, a number of vastly different types of etching processes, to selectively remove material has been successfully utilized to varying degrees. Moreover, the selective etching of different layers, within the microelectronic structure, is considered a critical and crucial step in the integrated circuit fabrication process.

In the manufacture of semiconductors and semiconductor microcircuits, it is frequently necessary to coat substrate materials with a polymeric organic substance. Examples of some substrate materials includes titanium, copper, silicon dioxide coated silicon wafer which may further include metallic elements of titanium, copper, and the like. Typically, the polymeric organic substance is a photoresist material. This is a material which will form an etch mask upon development after exposure to light. In subsequent processing steps, at least a portion of the photoresist is removed from the surface of the substrate. One common method of removing photoresist from a substrate is by wet chemical means. The wet chemical compositions formulated to remove the photoresist from the substrate should do so without corroding, dissolving, and/or dulling the surface of any metallic circuitry; chemically altering the inorganic substrate; and/or attacking the substrate itself. Another method of removing photoresist is by a dry ash method where the photoresist is removed by plasma ashing using either oxygen or forming gas such as hydrogen. The residues or by-products may be the photoresist itself or a combination of the photoresist, underlying substrate and/or etch gases. These residues or by-products are often referred to as sidewall polymers, veils or fences.

Increasingly, reactive ion etching (RIE) is the process of choice for pattern transfer during via, metal line and trench formation. For instance, complex semiconductor devices such as advanced DRAMS and microprocessors, which require multiple layers of back end of line interconnect wiring, utilize RIE to produce vias, metal lines and trench structures. Vias are used, through the interlayer dielectric, to provide contact between one level of silicon, silicide or metal wiring and the next level of wiring. Metal lines are conductive structures used as device interconnects. Trench structures are used in the formation of metal line structures. Bottom antireflective coating (BARC) and gap fill materials, which are typically highly cross-linked organic polymer materials, are widely used in semiconductor substrates containing copper. Vias, metal lines and trench structures typically expose metals and alloys such as Al-Cu, Cu, Ti, TiN, Ta, TaN, W, TiW, silicon or a silicide such as a silicide of tungsten, titanium or cobalt. The RIE process typically leaves a residue that may include re-sputtered oxide material as well as possibly organic materials from photoresist and antireflective coating materials used to lithographically define the vias, metal lines and or trench structures.

It would therefore be desirable to provide a selective cleaning composition and process capable of removing residues such as, for example, remaining photoresist and/or processing residues, such as for example, residues resulting from selective etching using plasmas and/or RIE. Moreover, it would be desirable to provide a selective cleaning composition and process, capable of removing residues such as photoresist and etching residue, that exhibits high selectivity for the residue as compared to metals, high dielectric constant materials (referred to herein as "high-k"), silicon, silicide and/or interlevel dielectric materials including low dielectric constant materials (referred to herein as "low-k"), such as deposited oxides that might also be exposed to the cleaning composition. It would be desirable to provide a composition that is compatible to and can be used with such sensitive low-k films as HSQ, MSQ, FOx, black diamond and TEOS (tetraethylsilicate).

### BRIEF SUMMARY OF THE INVENTION

The composition disclosed herein is capable of selectively removing residues such as, for example, photoresist, gap fill, BARC and/or other polymeric material, and/or inorganic material and processing residue from a substrate without attacking to any undesired extent metal, low-k dielectric, and/or high-k dielectric materials that might also be exposed to the composition. In certain embodiments, the composition disclosed herein may effectively remove residues while providing minimal corrosion to copper upon exposure.

In one aspect, there is provided a composition comprising: about 20 % to about 80 % by weight of an organic polar solvent; about 10 % to about 60 % by weight of water; about 1 % to about 10% by weight of a quaternary ammonium compound; optionally about 0.1 % to about 5 % by weight of a hydroxylamine provided that a mass ratio of the hydroxylamine if present to quaternary ammonium compound is less than 3; optionally about 0.1 % to about 10 % by weight of a fluoride ion source, and a mercapto-containing corrosion inhibitor selected from the group consisting of a compound having a following formula (I), a compound having a following formula (II), 2-mercaptothiazoline, 3-mercaptopropyl-trimethoxysilane, and mixtures thereof 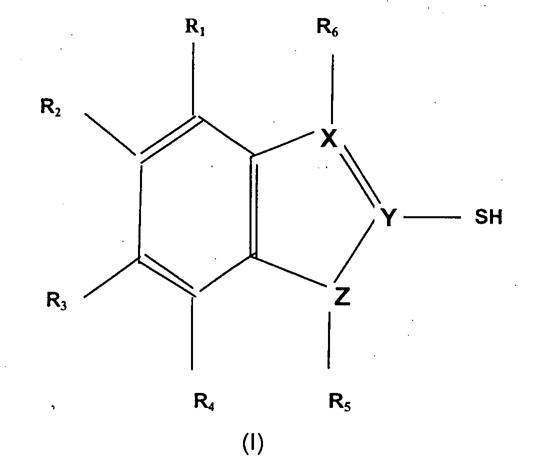 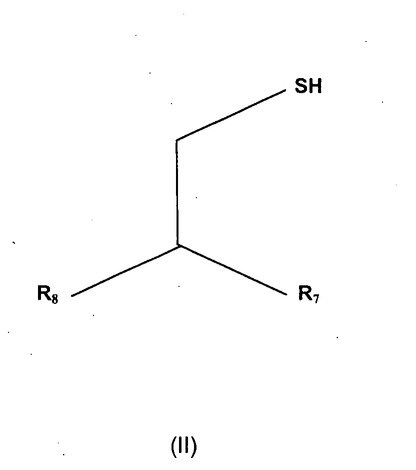 wherein X, Y, and Z are each independently selected from C, N, O, S, and P; R₁, R₂, R₃, R₄, R₅, and R₆ are each independently an alkyl group having a formula CₙH₂ₙ₊₁, wherein n ranges from 0 to 20; R₇ is one selected from H, -OH, -COOH, and -NH₂; and R₈ is one selected from an alkyl group having a formula CₙH₂ₙ₋₁, wherein n ranges from 0 to 20 or an alkanol group having a formula CₙH₂ₙOH wherein n ranges from 0 to 20.

In another aspect, there is provided a composition comprising: about 20 % to about 80 % by weight of an organic polar solvent; about 10 % to about 60 % by weight of water; about 1 % to about 10% by weight of a quaternary ammonium compound; and a mercapto-containing corrosion inhibitor selected from the group consisting of a compound having a following formula (I), a compound having a following formula (II), 2-mercaptothiazoline, 3-mercaptopropyl-trimethoxysilane, and mixtures thereof 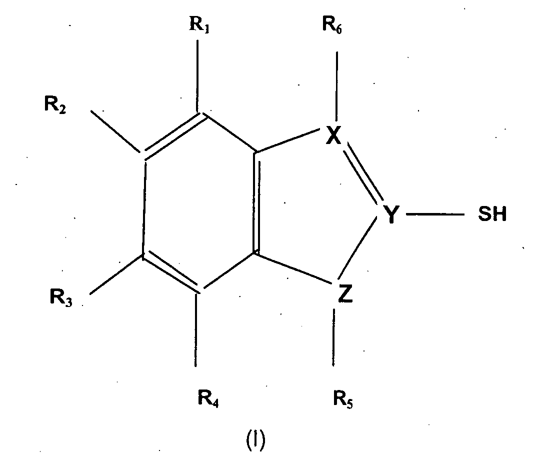 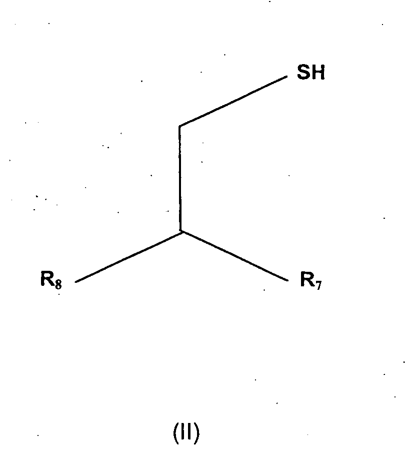 wherein X, Y, and Z are each independently selected from C, N, O, S, and P; R₁, R₂, R₃, R₄, R₅, and R₆ are each independently an alkyl group having a formula CₙH₂ₙ₊₁, wherein n ranges from 0 to 20; R₇ is one selected from H, -OH, -COOH, and -NH₂; and R₈ is one selected from an alkyl group having a formula CₙH₂ₙ₊₁, wherein n ranges from 0 to 20 or an alkanol group having a formula CₙH₂ₙOH wherein n ranges from 0 to 20 and wherein the composition is substantially free of a water-soluble amine.

In a further aspect, there is provided a composition, for removing residues from a substrate comprising copper, comprising: an organic polar solvent; water; a quaternary ammonium compound; optionally hydroxylamine provided that the mass ratio of hydroxylamine if present to quaternary ammonium compound is less than 3; and a mercapto-containing corrosion inhibitor selected from the group consisting of a compound having a following formula (I), a compound having a following formula (II), 2-mercaptothiazoline, 3-mercaptopropyl-trimethoxysilane, and mixtures thereof 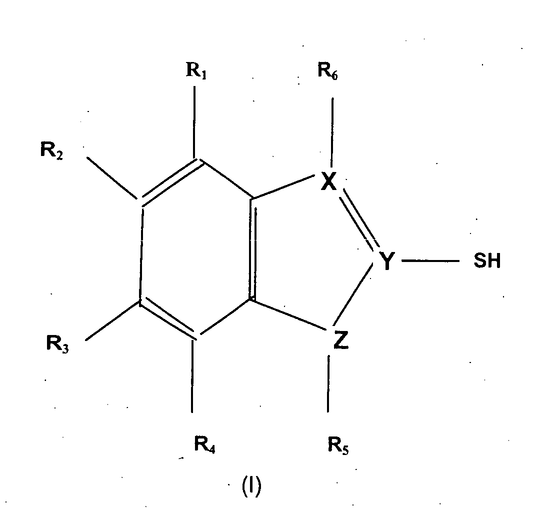 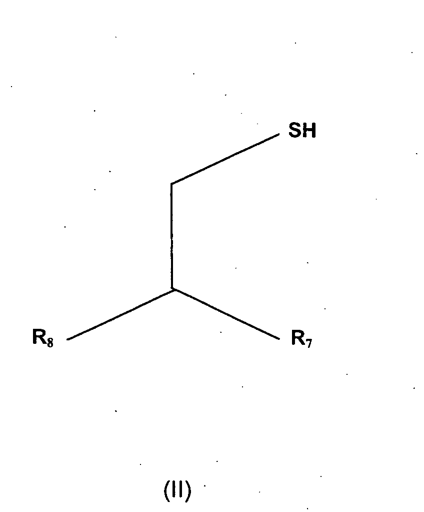 wherein X, Y, and Z are each independently selected from C, N, O, S, and P; R₁, R₂, R₃, R₄, R₅, and R₅ are each independently an alkyl group having a formula CₙH₂ₙ₊₁, wherein n ranges from 0 to 20; R₇ is one selected from H, -OH, -COOH, and -NH₂; and R₈ is one selected from an alkyl group having a formula CₙH₂ₙ₊₁, wherein n ranges from 0 to 20 or an alkanol group having a formula CₙH₂ₙOH wherein n ranges from 0 to 20 and wherein the composition exhibits a copper etch rate that is less than 5 angstroms/minute.

Also disclosed herein is a method for removing residues from a substrate that comprises contacting the substrate with the composition described herein.

### DETAILED DESCRIPTION OF THE INVENTION

A composition and method comprising same for selectively removing residues such as, for example, photoresist, gap fill, bottom antireflective coating (BARC) and other polymeric materials and/or processing residues such as the residues generated by etching are described herein. In a cleaning method involving substrates useful for microelectronic devices, typical contaminants to be removed may include, for example, organic compounds such as exposed and/or ashed photoresist material, ashed photoresist residue, UV- or X-ray-hardened photoresist, C-F-containing polymers, low and high molecular weight polymers, and other organic etch residues; inorganic compounds such as metal oxides, ceramic particles from chemical mechanical planarization (CMP) slurries and other inorganic etch residues; metal containing compounds such as organometallic residues and metal organic compounds; ionic and neutral, light and heavy inorganic (metal) species, moisture, and insoluble materials, including particles generated by processing such as planarization and etching processes. In one particular embodiment, residues removed are processing residues such as those created by reactive ion etching.

The residues are typically present in a substrate that also includes metal, silicon, silicate and/or interlevel dielectric materials such as, for example, deposited silicon oxides and derivatized silicon oxides such as HSQ, MSQ, FOX, TEOS and spin-on glass, chemical vapor deposited dielectric materials, low-k materials and/or high-k materials such as hafnium silicate, hafnium oxide, barium strontium titanate (BST), TiO₂, TaO₅, wherein both the residues and the metal, silicon, silicide, interlevel dielectric materials, low-k and/or high-k materials will come in contact with the cleaning composition. The composition and method disclosed herein provide for selectively removing the residues such as photoresist, BARC, gap fill, and/or processing residues without significantly attacking the metal, silicon, silicon dioxide, interlevel dielectric materials, low-k and/or high-k materials. In certain embodiments, the substrate may contain a metal, such as, but not limited to, copper; copper alloy, titanium, titanium nitride, tantalum, tantalum nitride, tungsten, and/or titanium/tungsten alloys. In one embodiment, the composition disclosed herein may be suitable for substrates containing sensitive low-k -films. In one particular embodiment, residues removed are processing residues such as those created by reactive ion etching.

The compositions disclosed herein may comprise from about 20 % to about 80% by weight of an organic polar solvent; from about 10 % to about 60% by weight of water; from about 1 % to about 10% by weight of a quaternary ammonium compound; optionally from about 0.1 % to about 5% by weight of a hydroxylamine provided that a mass ratio of hydroxylamine if present to quaternary ammonium compound is less than 3; optionally from about 0.1 % to about 10 % by weight of a fluoride ion source, and a mercapto-containing corrosion inhibitor selected from the group consisting of a compound having a following formula (I), a compound having a following formula (II), 2-mercaptothiazoline, 3-mercaptopropyl-trimethoxysilane, and mixtures thereof 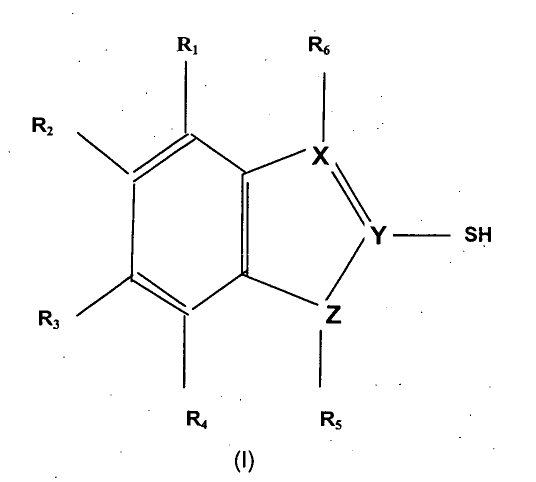 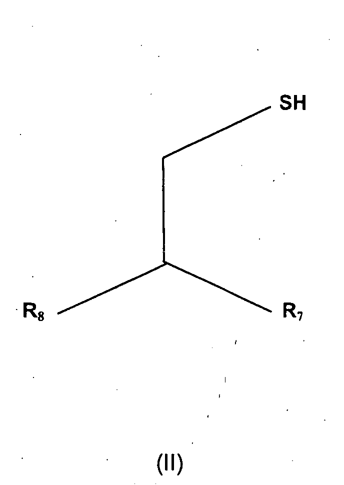 wherein X, Y, and Z are each independently selected from C, N, O, S, and P; R₁, R₂, R₃, R₄, R₅, and R₅ are each independently an alkyl group having a formula CₙH₂ₙ₊₁, wherein n ranges from 0 to 20; R₇ is one selected from H, -OH, -COOH, and -NH₂; and R₈ is one selected from an alkyl group having a formula CₙH₂ₙ₊₁, wherein n ranges from 0 to 20 or an alkanol group having a formula CₙH₂ₙOH wherein n ranges from 0 to 20. Mercapto-containing corrosion inhibitors having the formulas (I) and (II) include mercapto organic compounds such as mercapto alkane, mercapto alkanol, mercapto alanediol, and mercapto aromatic compounds. In certain embodiments, the mercapto-containing corrosion inhibitor may include 2-mercapto-5-methylbenzimidazole, 2-mercaptothiazoline, 3-mercapto-1,2-propanediol, 3-mercaptopropyl-trimethoxysilane, and mixtures thereof. In alternative embodiments, the composition disclosed herein is substantially free of a water soluble amine or any additional component that adversely affects the stripping and cleaning ability of the composition or damages one or more surfaces of the underlying substrate. In embodiments wherein the substrate contains, *inter alia,* copper, the composition exhibits a copper etch rate of less than 5 angstroms/minute.

The composition disclosed herein contains an organic polar solvent that is preferably water-soluble. Examples of organic polar solvents include, but are not limited to, dimethylacetamide (DMAC), N-methyl pyrrolidinone (NMP), dimethylsulfoxide (DMSO), dimethylformamide, N-methylformamide, formamide, dimethyl-2-piperidone (DMPD), tetrahydrofurfuryl alcohol, glycerol, ethylene glycol, and other amides, alcohols or sulfoxides, or multifunctional compounds, such as hydroxyamides or amino alcohols. Further examples of the organic polar solvent include diols and polyols such as (C₂- C₂₀) alkanediols and (C₃- C₂₀) alkanetriols, cyclic alcohols and substituted alcohols. Particular examples of these auxiliary organic solvents are propylene glycol, tetrahydrofurfuryl alcohol, diacetone alcohol and 1, 4-cyclohexanedimethanol. In certain embodiments, the organic polar solvent may be DMSO, NMP, and/or DMAC. The organic polar solvent enumerated above may be used alone or in combination with two or more solvents.

In certain embodiments, the organic polar solvent may comprise a glycol ether. Examples of glycol ethers include ethylene glycol monomethyl ether, ethylene glycol monoethyl ether, ethylene glycol monobutyl ether, ethylene glycol dimethyl ether, ethylene glycol diethyl ether, diethylene glycol monomethyl ether, diethylene glycol monoethyl ether, diethylene glycol monopropyl ether, diethylene glycol monoisopropyl ether, diethylene glycol monobutyl ether, diethylene glycol monoisobutyl either, diethylene glycol monobenzyl ether, diethylene glycol dimethyl ether, diethylene glycol diethyl ether, triethylene glycol monomethyl ether, triethylene glycol dimethyl ether, polyethylene glycol monomethyl ether, diethylene glycol methyl ethyl ether, triethylene glycol ethylene glycol monomethyl ether acetate, ethylene glycol monethyl ether acetate, propylene glycol methyl ether acetate, propylene glycol monomethyl ether, propylene glycol dimethyl ether, propylene glycol monobutyl ether, propylene glycol, monopropyl ether, dipropylene glycol monomethyl ether, dipropylene glycol monopropyl ether, dipropylene glycol monoisopropyl ether, dipropylene monobutyl ether, diproplylene glycol diisopropyl ether, tripropylene glycol monomethyl ether, 1-methoxy-2-butanol, 2-methoxy-1-butanol, 2-methoxy-2-methylbutanol, 1,1-dimethoxyethane and 2-(2-butoxyethoxy) ethanol.

Water is also present in the composition disclosed herein. It can be present incidentally as a component of other elements, such as for example, an aqueous solution comprising the fluoride ion source or quaternary ammonium compound, or it can be added separately. Some non-limiting examples of water include deionized water, ultra pure water, distilled water, doubly distilled water, or deionized water having a low metal content. Preferably, water is present in amounts of from about 10 % to about 60% by weight or from about 20 % to about 40 % by weight.

The composition also includes one or more quaternary ammonium compound having the formula [N-R₉R₁₀R₁₁R₁₂]⁺ OH⁻ wherein R₉, R₁₀, R₁₁, and R₁₂ are each independently an alkyl group of 1 to 20 carbon atoms. The term "alkyl" refers to straight or branched chain unsubstantiated hydrocarbon groups of 1 to 20 carbon atoms, or from 1 to 8 carbon atoms, or from 1 to 4 carbon atoms. Examples of suitable alkyl groups include methyl, ethyl, propyl, isopropyl, butyl, and tertbutyl. The expression "lower alkyl" refers to alkyl groups of 1 to 4 carbon atoms. Examples of suitable quaternary ammonium compounds include tetramethylammonium hydroxide (TMAH), tetraethylammonium hydroxide, tetrabutylammonium hydroxide (TBAH), tetrapropylammonium hydroxide, trimethylethylammonium hydroxide, (2-hydroxyethyl)trimethylammonium hydroxide, (2-hydroxyethyl)triethylammonium hydroxide, (2-hydroxyethyl)tripropylammonium hydroxide, (1-hydroxypropyl)trimethylammonium hydroxide, ethyltrimethylammonium hydroxide, diethyldimethylammonium hydroxide and benzyltrimethylammonium hydroxide. The quaternary ammonium compounds are present in an amount ranging from about 1 % to about 10% or from about 5 % to about 10% by weight.

In certain embodiments, the composition may optionally include from about 0.1 % to about 5% by weight of a hydroxylamine or an acid salt thereof. In these embodiments, the mass ratio of quaternary ammonium hydroxide to hydroxylamine is less than 3. Exemplary hydroxylamines include diethylhydroxylamine and the lactic acid and citric acid salts thereof. Ordinarily, hydroxylamines are not considered as being compatible with copper because of their ability to etch. However, in the composition disclosed herein these compounds surprisingly inhibit copper corrosion.

In other embodiments, the composition is substantially free of, or contains less than 0.1 % by weight, of a water soluble amine.

In certain embodiments, the composition may optionally include a fluoride ion source typically in an amount of from about 0.1 % to about 10% by weight, or from about 5 to about 10% by weight. Examples of certain fluoride ion sources include those of the general formula R₁₃R₁₄R₁₅R₁₆NF where R₁₃, R₁₄, R₁₅, and R₁₆ are each independently hydrogen, an alkanol group, an alkoxy group, an alkyl group or mixtures thereof. Examples of such compounds include ammonium fluoride, tetramethyl ammonium fluoride, tetraethyl ammonium fluoride, tetrabutyl ammonium fluoride, and mixtures thereof. Still further examples of fluoride ion sources include fluoroboric acid, hydrofluoric acid, fluoroborates, fluoroboric acid, tetrabutylammonium tetrafluoroborate, aluminum hexafluoride, and choline fluoride. In still further embodiments, the fluoride ion source is a fluoride salt of an aliphatic primary, secondary or tertiary amine can be used.

The compositions of the present disclosure can contain from about 0.1 to about 5% by weight of a mercapto-containing corrosion inhibitor selected from the group consisting of a compound having a following formula (I), a compound having a following formula (II), 2-mercaptothiazoline, 3-mercaptopropyl-trimethoxysilane, and mixtures thereof 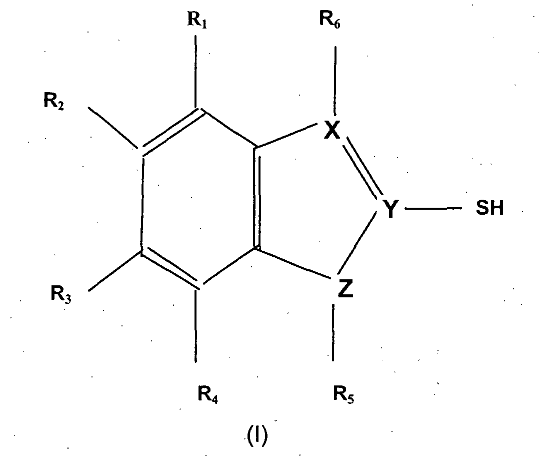 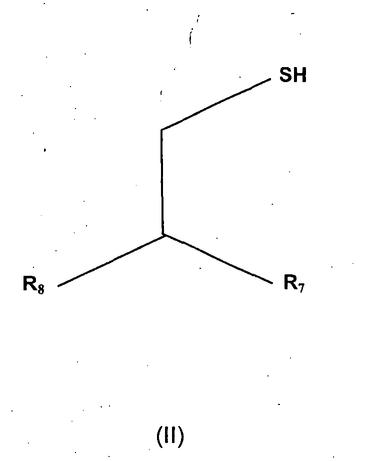 wherein X, Y, and Z are each independently selected from C, N, O, S, and P; R₁, R₂, R₃, R₄, R₅, and R₆ are each independently an alkyl group having a formula CₙH₂ₙ₋₁, wherein n ranges from 0 to 20; R₇ is one selected from H, -OH, -COOH, and -NH₂; and R₈ is one selected from an alkyl group having a formula CₙH₂ₙ₊₁, wherein n ranges from 0 to 20 or an alkanol group having a formula CₙH₂ₙOH wherein n ranges from 0 to 20. Specific examples of mercapto-containing corrosion inhibitors include 2-mercapto-5-methylbenzimidazole (a formula (I) compound), 3-mercapto-1,2-propanediol (which is also referred to as thioglycerol and is a formula (II) compound), 2-mercaptothiazoline (neither formula (I) nor (II) compounds), 3-mercaptopropyl-trimethoxysilane (neither formula (I) nor (II) compounds) and mixtures thereof.

The composition disclosed herein may further comprise one or more additional corrosion inhibitors in addition to the mercapto-containing corrosion inhibitors provided that these additional corrosion inhibitors do not adversely effect the stripping and cleaning performance of the composition nor damage the underlying substrate surface. Examples of these additional corrosion inhibitors include, but are not limited to, organic acids (e.g., anthranilic acid, gallic acid, benzoic acid, malonic acid, maleic acid, fumaric acid, D,L-malic acid, isophthalic acid, phthalic acid, and lactic acid), organic acid salts, catechol, benzotriazole (BZT), resorcinol, other phenols, acids or triazoles maleic anhydride, phthalic anhydride, catechol, pyrogallol, esters of gallic acid, benzotriazole (BZT), carboxybenzotriazole, fructose, ammonium thiosulfate, glycine, tetramethylguanidine, iminodiacetic acid, dimethylacetoacetamide, trihydroxybenzene, dihydroxybenzene, salicyclohydroxamic, and mixtures thereof.

The composition may also include one or more of the following additives: surfactants, chelating agents, chemical modifiers, dyes, biocides, and other additives. Additives may be added to the composition described herein provided that it does not adversely affect the stripping and cleaning ability of the composition or the integrity of the underlying metal, silicon, silicon dioxide, interlevel dielectric materials, low-k and/or high-k materials. For example, if the composition if used to treat a substrate containing copper, the composition does not include additional additives that would increase the copper etch rate of the composition. Some examples of representative additives include acetylenic alcohols and derivatives thereof, acetylenic diols (non-ionic alkoxylated and/or self-emulsifiable acetylenic diol surfactants) and derivatives thereof, alcohols, quaternary amines and di-amines, amides (including aprotic solvents such as dimethyl formamide and dimethyl acetamide), alkyl alkanolamines (such as diethanolethylamine), and chelating agents such as beta-diketones, beta-ketoimines, carboxylic acids, mallic acid and tartaric acid based esters and diesters and derivatives thereof, and tertiary amines, diamines and triamines.

The compositions disclosed herein may have a pH that ranges from about 10 to about 14, or from about 11 to about 13.

Compositions disclosed herein are compatible with substrates containing low-k films such as HSQ (FOx), MSQ, SiLK, etc. including those low-k films containing a fluoride. The compositions are also effective in stripping photoresists including positive and negative photoresists and plasma etch residues such as organic residues, organometallic residues, inorganic residues, metallic oxides, or photoresist complexes at low temperatures with very low corrosion of copper, and/or titanium containing substrates. Moreover, the compositions are compatible with a variety of metal, silicon, silicon dioxide, interlevel dielectric materials, low-k and/or high-k materials.

During the manufacturing process, a photoresist layer is coated on the substrate. Using a photolithographic process, a pattern is defined on the photoresist layer. The patterned photoresist layer is thus subjected to plasma etch by which the pattern is transferred to the substrate. Etch residues are generated in the etch stage. Some of the substrates used in this invention are ashed while some are not ashed. When the substrates are ashed, the main residues to be cleaned are etchant residues. If the substrates are not ashed, then the main residues to be cleaned or stripped are both etch residues and photoresists.

The method described herein may be conducted by contacting a substrate having a metal, organic or metal-organic polymer, inorganic salt, oxide, hydroxide, or complex or combination thereof present as a film or residue, with the described composition. The actual conditions, e.g. temperature, time, etc., depend on the nature and the thickness of the material to be removed. In general, the substrate is contacted or dipped into a vessel containing the composition at a temperature ranging from 20°C to 85°C, or from 20°C to 60°C, or from 20°C and 40°C. Typical time periods for exposure of the substrate to the composition may range from, for example, 0.1 to 60 minutes, or 1 to 30 minutes, or 1 to 15 minutes. After contact with the composition, the substrate may be rinsed and then dried. Drying is typically carried out under an inert atmosphere. In certain embodiments, a deionized water rinse or rinse containing deionized water with other additives may be employed before, during, and/or after contacting the substrate with the composition described herein. However, the composition can be used in any method known in the art that utilizes a cleaning fluid for the removal of photoresist, ash or etch residues and/or residues.

### EXAMPLES

The following examples are provided to further illustrate the composition and method disclosed herein. In the following examples, all amounts are given in weight percent and add up to 100 weight percent. The compositions disclosed herein were prepared by mixing the components together in a vessel at room temperature until all solids have dissolved.

For the following examples, one or more test substrates were placed in a 600 milliliter (ml) beaker that contained 400 ml of each exemplary composition. The 600 ml beaker further included a 1" stir bar that rotated at 400 revolutions per minute. The exemplary compositions having the wafer(s) contained therein were then heated at the time and temperature provided in each example. After exposure to the exemplary composition, the wafer(s) were rinsed with deionized water and dried with nitrogen gas. The wafers were then evaluated using scanning electron microscopy (SEM) in a variety of locations to determine, *inter alia,* the extent of photo resist removal, BARC or gap fill removal, and underlying ILD damage.

### Example 1: Removal of Photoresist Residues

Silicon wafer test substrates having a low-k, silicon oxide-containing dielectric film and a photoresist pattern etched for a multi-layer interconnect were etched using a plasma etching process. The substrates were then processed by immersing the substrate in a variety of exemplary compositions and a comparative composition provided in Table I for time and temperature described in Table II. A scanning electronic microscope (SEM) was used to evaluate the cleaning performance. The cleaning performance results are provided in Table II. The results provided in Table II illustrate that that exemplary formulations 1A and 1 B can effectively clean photoresist.

**Table I: Compositions:**

| | Composition |
|---|---|
| Comparative Example 1 | Water: 20.0 wt % Ammonium Fluoride (NH₄OH) (29% water solution): 20.0 wt% Dimethylsulfoxide (DMSO): 60.0 wt% |
| Example 1A | Tetramethyl ammonium hydroxide (TMAH) ( 25 % water solution) : 30.0 wt% Dimethylsulfoxide (DMSO): 68.5 wt% Hydroxylamine (HA) (50% water solution): 0.5 wt% 3-Mercapto-1,2-propanediol (thioglycerol) : 1.0 wt% Mass Ratio of HA /TMAH: 0.25/0.75 = 0.0333 |
| Example 1 B | TMAH ( 25 % water solution) : 30.0 wt% DMSO: 58.5 wt% DI Water: 10.0 wt% HA (50% water solution): 0.5 wt % 3-Mercapto-1,2-propanediol (thioglycerol) : 1.0 wt% Mass Ratio of HA /TMAH: 0.25/0.75 = 0.0333 |

**Table II: Photoresist Cleaning Experiment**

| Composition | Process Temperature (°C) | Process Time (minutes) | Photoresist Cleaning Result |
|---|---|---|---|
| Comparative Example 1 | 75 | 40 | Not Clean |
| Example 1A | 65 | 40 | 90 % Clean |
| Example 1B | 65 | 40 | > 95% Clean |

### Example 2: Removal of Polymeric (e.g., gap fill or BARC) Residues after Plasma Etching

Example 2 illustrates the effectiveness of various exemplary compositions for removing polymeric materials such as gap fill or BARC material from a silicon wafer substrate after plasma etching. Silicon wafer test substrates having a low-k, silicon oxide-containing dielectric film, a BARC layer, and a photoresist pattern etched for a multi-layer interconnect were etched using a plasma etching process. The substrates were then processed by immersing the substrate in a variety of exemplary compositions and comparative compositions provided in Table III for time and temperature described in Table IV. A SEM was used to evaluate the cleaning performance and damage to the underlying interlevel dielectric layer (ILD) and the results are provided in Table IV. The results illustrate that the exemplary compositions, particularly compositions 2B and 2C, can effectively clean gap fill or BARC material without attacking the ILD layer.

**Table III: Compositions**

| | Composition |
|---|---|
| Comparative Example 2A | Water: 20.0 wt% TMAH ( 25 % water solution) : 30.0 wt% N-methyl pyrrolidinone (NMP) : 50 wt% |
| Comparative Example 2B | Water: 9.5 wt% TMAH ( 25% water solution) : 30.0 wt% DMSO : 55.0 wt% DEHA : 5.0 wt% SURFYNOL™ S485 : 0.5 wt% Mass Ratio of DEHA/TMAH: 5/7.5 = 0.667 |
| Example 2A | TMAH (25 % water solution): 30.0 wt% DMSO: 68.5 wt% 3-Mercapto-1,2-propanediol (thioglycerol) : 1.5 wt% |
| Example 2B | TMAH ( 25% water solution): 40.0 wt% DMSO : 58.0 wt% hydroxylamine ( 50% water solution): 1.0 wt% 3-Mercapto-1,2-propanediol (thioglycerol) : 1.0 wt% Mass Ratio of HA/TMAH: 0.5/10 = 0.05 |
| Example 2C | TMAH ( 25% water solution) : 40.0 wt% DMSO : 56.0 wt % TMAF (20% water solution) : 2.0 wt% hydroxylamine ( 50% water solution): 1.0 wt% 3-Mercapto-1,2-propanediol (thioglycerol) : 1.0 wt% Mass Ratio of HA/TMAH: 0.5/10 = 0.05 |

**Table IV: Gap Fill Material (BARC) Cleaning Experiment**

| Formulation | Process Temperature (°C) | Process Time (minutes) | Result | |
|---|---|---|---|---|
| | | | Gap Fill Material Cleaning | ILD Damage |
| Comparative Example 2A | 75 | 30 | Not Clean | Yes |
| Comparative Example 2B | 75 | 40 | 50 % removed | Yes |
| Example 2A | 75 | 20 | Not Clean | No |
| Example 2B | 75 | 20 | 100% Removed | No |
| Example 2C | 75 | 20 | 100% Removed | No |

### Example 3: Copper Etch Rate

Example 3 illustrates the degree of metal corrosion present to a metal film when substrates coated with a metal film are exposed to comparative and exemplary compositions for varying time periods. A copper film was sputtered onto silicon oxide wafer substrate. The initial thickness of the copper film on the wafers was measured using the CDE ResMap 273 Four Point Probe. After determining the initial thickness, test substrates were then immersed in the compositions provided in Table V at the temperatures provided in Table VI for 5, 10, 20, 40 and 60 minute intervals. After immersion in each time interval, the test substrates were removed from each composition, rinsed for three minutes with deionized water, and completely dried under nitrogen. Thickness measurements were determined at each time interval and graphed using a "least squares fit" model on the results for each exemplary composition. The calculated slope of the "least squares fit" model of each composition is the resultant etch rate provided in angstroms/minute (Å/min). The copper etch rate is used the linear fit for thickness change against to the immersed time. The summary of etch rates ("ER") are provided in Table VI. Table VI illustrates that test substrates treated with the exemplary compositions, particularly examples 3B through 3F, exhibited substantially lower copper etch rates when compared to those substrates treated with comparative examples 3A through 3D.

**Table V: Composition**

| | Composition |
|---|---|
| Comparative Example 3A | Water: 10.0 wt% TMAH ( 25% water solution) : 30.0 wt% DMSO : 59.0 wt% Hydroxylamine (HA)( 50% water solution) : 1.0 wt% Mass Ratio of HA/TMAH: 0.5/7.5 = 0.0667 |
| Comparative Example 3B | Water: 10.0 wt% TMAH ( 25% water solution) : 30.0 wt% DMSO : 57.5 wt% HA ( 50% water solution) : 0.5 wt% DEHA : 2.0 wt% Mass Ratio of HA and DEHA/TMAH: 2.25/7.5 = 0.3 |
| Comparative Example 3C | Water: 10.0 wt% TMAH ( 25% water solution) : 30.0 wt% DMSO : 58.5 wt% HA ( 50% water solution) : 0.5 wt% Gallic Acid : 1.0 wt% Mass Ratio of HA/TMAH: 0.25/7.5 = 0.0333 |
| Comparative Example 3D | Water: 10.0 wt% TMAH ( 25% water solution) : 30.0 wt% DMSO : 58.5 wt% HA ( 50% water solution) : 0.5 wt% Benzotriazole (BZT) : 1.0 wt% Mass Ratio of HA/TMAH: 0.25/7.5 = 0.0333 |
| Example 3A | TMAH ( 25% water solution) : 30.0 wt% DMSO : 68.0 wt% HA ( 50% water solution) : 1.0 wt% Mercaptobenzoxazole : 1.0 wt% Mass Ratio of HA/TMAH: 0.5/7.5 = 0.0667 |
| Example 3B | TMAH ( 25% water solution) : 30.0 wt% DMSO : 68.5 wt% HA ( 50% water solution) : 1.0 wt% 2-mercapto-5-methylbenzimidazole : 0.5 wt% Mass Ratio of HA/TMAH: 0.5/7.5 = 0.0667 |
| Example 3C | TMAH ( 25% water solution) : 30.0 wt% DMSO : 68.0 wt% HA ( 50% water solution) : 1.0 wt% 3-Mercapto-1,2-propanediol (thioglycerol) : 1.0 wt% Mass Ratio of HA/TMAH: 0.5/7.5 = 0.0667 |
| Example 3D | TMAH (25 % water solution): 40.0 wt% DMSO: 59 wt% 3-Mercapto-1,2-propanediol (thioglycerol) : 1.0 wt% |
| Example 3E | TMAH (25 % water solution): 40.0 wt% DMSO: 58.0% wt% 3-Mercapto-1,2-propanediol (thioglycerol) : 2.0 wt% |
| Example 3F | TMAH ( 25% water solution) : 30.0 wt% DMSO : 68.0 wt% HA ( 50% water solution) : 1.0 wt% Mercaptothiazoline : 1.0 wt% Mass Ratio of HA/TMAH: 0.5/7.5 = 0.0667 |

**Table VI: Cu Etch Rate Test:**

| Composition | Process Temperature (°C) | Cu Etch Rate (A/min) |
|---|---|---|
| Comparative Example 3A | 75 | 28 |
| Comparative Example 3B | 75 | 21 |
| Comparative Example 3C | 75 | 112 |
| Comparative Example 3D | 75 | 28 |
| Example 3A | 75 | 31 |
| Example 3B | 75 | 3 |
| Example 3C | 75 | 1 |
| Example 3D | 55 | 1 |
| Example 3E | 55 | 1 |
| Example 3F | 75 | 1 |

## Claims

1. A composition for removing residues from a substrate, the composition comprising:
about 20 % to about 80 % of an organic polar solvent;
about 10 % to about 60 % by weight of water;
about 1 % to about 10 % by weight of a quaternary ammonium compound;
optionally about 0.1 % to about 5 % by weight of hydroxylamine provided that a mass ratio of hydroxylamine if present to quaternary ammonium compound is less than 3;
optionally about 0.1 % to about 10 % by weight of a fluoride ion source; and
a mercapto-containing corrosion inhibitor selected from the group consisting of a compound having a following formula (I), a compound having a following formula (II), 2-mercaptothiazoline, 3-mercaptopropyl-trimethoxysilane, and mixtures thereof 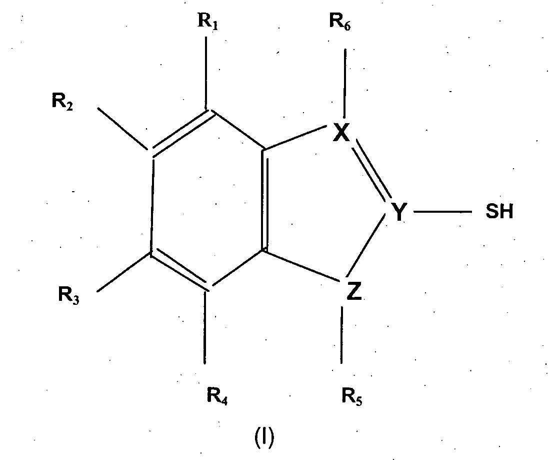 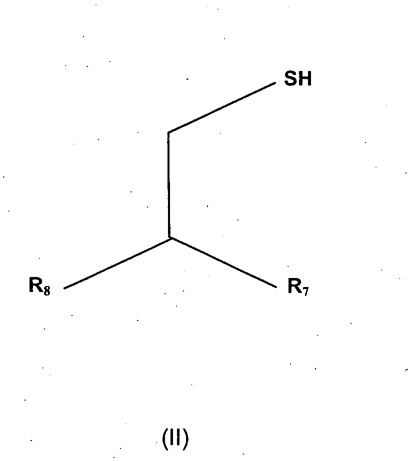
wherein X, Y, and Z are each independently selected from C, N, O, S, and P; R₁, R₂, R₃, R₄, R₅, and R₆ are each independently an alkyl group having a formula CₙH₂ₙ₊₁, wherein n ranges from 0 to 20; R₇ is one selected from H, -OH, -COOH, and -NH₂; and R₈ is one selected from an alkyl group having a formula CₙH₂ₙ₊₁, wherein n ranges from 0 to 20 or an alkanol group having a formula CₙH₂ₙOH wherein n ranges from 0 to 20.

2. The composition of claim 1 wherein the organic polar solvent is selected from the group consisting of dimethylacetamide, N-methyl pyrrolidinone, dimethylsulfoxide, dimethylformamide, N-methylformamide, formamide, dimethyl-2-piperidone, tetrahydrofurfuryl alcohol, glycerol, glycol ether, and mixtures thereof.

3. The composition of claim 2 wherein the organic polar solvent is selected from the group consisting of dimethylacetamide, dimethylsulfoxide, N-methyl pyrrolidinone, and mixtures thereof.

4. The composition of claim 2 wherein the organic polar solvent comprises the glycol ether.

5. The composition of claim 4 wherein the glycol ether is selected from the group consisting of ethylene glycol monomethyl ether, ethylene glycol monoethyl ether, ethylene glycol monobutyl ether, ethylene glycol dimethyl ether, ethylene glycol diethyl ether, diethylene glycol monomethyl ether, diethylene glycol monoethyl ether, diethylene glycol monopropyl ether, diethylene glycol monoisopropyl ether, diethylene glycol monobutyl ether, diethylene glycol monoisobutyl ether, diethylene glycol monobenzyl ether, diethylene glycol dimethyl ether, diethylene glycol diethyl ether, triethylene glycol monomethyl ether, triethylene glycol dimethyl ether, polyethylene glycol monomethyl ether, diethylene glycol methyl ethyl ether, triethylene glycol ethylene glycol monomethyl ether acetate, ethylene glycol monoethyl ether acetate, propylene glycol monomethyl ether, propylene glycol dimethyl ether, propylene glycol monobutyl ether, propylene glycol, monopropyl ether, dipropylene glycol monomethyl ether, dipropylene glycol monopropyl ether, dipropylene glycol monoisopropyl ether, dipropylene monobutyl ether, dipropylene glycol diisopropyl ether, tripropylene glycol monomethyl ether, 1-methoxy-2-butanol, 2-methoxy-1-butanol, 2-methoxy-2-methylbutanol, 1,1-dimethoxyethane, and 2-(2-butoxyethoxy) ethanol.

6. The composition of claim 1 wherein the quaternary ammonium compound comprises a lower alkyl quaternary ammonium compound.

7. The composition of claim 6 wherein the lower alkyl quaternary ammonium compound is selected from the group consisting of tetramethylammonium hydroxide, tetraethylammonium hydroxide, tetrapropylammonium hydroxide, tetrabutylammonium hydroxide, trimethylethylammonium hydroxide, (2-hydroxyethyl)trimethylammonium hydroxide, (2-hydroxyethyl)triethylammonium hydroxide, (2-hydroxyethyl)tripropylammonium hydroxide, (1-hydroxypropyl)trimethylammonium hydroxide, and mixtures thereof.

8. The composition of claim 1 wherein the composition comprises the hydroxylamine.

9. The composition of claim 8 wherein the hydroxylamine comprises diethyl hydroxylamine.

10. The composition of claim 1 wherein the composition further comprises an additional corrosion inhibitor.

11. The composition of claim 10 wherein the additional corrosion inhibitor is at least one selected from anthranilic acid, gallic acid, benzoic acid, malonic acid, maleic acid, fumaric acid, D,L-malic acid, isophthalic acid, phthalic acid, lactic acid, maleic anhydride, phthalic anhydride, catechol, pyrogallol, esters of gallic acid, benzotriazole, carboxybenzotriazole, fructose, ammonium thiosulfate, glycine, tetramethylguanidine, iminodiacetic acid, dimethylacetoacetamide, trihydroxybenzene, dihydroxybenzene, salicyclhydroxamic, and mixtures thereof.

12. The composition of claim 1 wherein the mercapto-containing corrosion inhibitor is one selected from the group consisting of 2-mercapto-5-methylbenzimidazole, 3-mercapto-1,2-propanediol, 2-mercaptothiazoline, 3-mercaptopropyl-trimethoxysilane, and mixtures thereof.

13. The composition of claim 1 comprising the fluoride ion source.

14. The composition of claim 13 wherein the fluoride ion source comprises a compound having a general formula R₁₃,R₁₄,R₁₅,R₁₆NF where R₁₃,R₁₄,R₁₅ and R₁₆ are independently hydrogen, an alkanol group, an alkoxy group, an alkyl group and mixtures thereof.

15. The composition of claim 14 wherein the fluoride ion source is selected from ammonium fluoride, tetramethyl ammonium fluoride, tetraethyl ammonium fluoride, tetrabutyl ammonium fluoride, choline fluoride, and mixtures thereof.

16. The composition of claim 13 wherein the fluoride ion source comprises fluoroboric acid.

17. A method of removing residue from the substrate comprising: applying a composition according to claim 1 to the substrate at a temperature of from 20°C to 80°C for a period of time sufficient to remove the residue from the substrate.

18. The method of claim 17 wherein the substrate comprises at least one material selected from the consisting of group consisting of metal, silicon, silicate, interlevel dielectric material, low-k dielectric, and high-k dielectric.

19. The method of claim 18 wherein the metal is selected from the group consisting of copper, copper alloy, titanium, titanium nitride, tantalum, tantalum nitride, tungsten, and titanium/tungsten alloys.

20. A composition for removing residues from a substrate, the composition comprising:
about 20 % to about 80 % of an organic polar solvent;
about 10 % to about 60 % by weight of water;
about 1 % to about 10 % by weight of a quaternary ammonium compound; and
a mercapto-containing corrosion inhibitor selected from the group consisting of a compound having a following formula (I), a compound having a following formula (II), 2-mercaptothiazoline, 3-mercaptopropyl-trimethoxysilane, and mixtures thereof 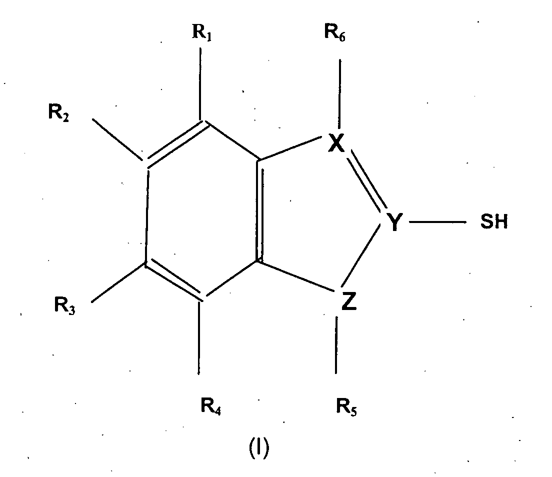 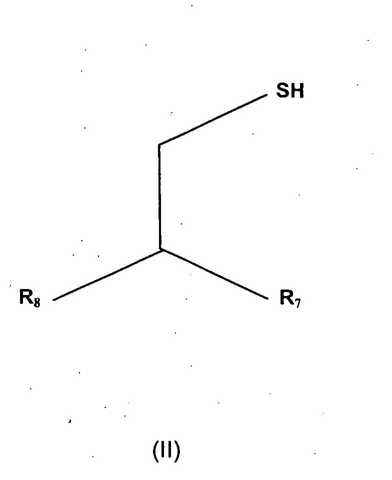
wherein X, Y, and Z are each independently selected from C, N, O, S, and P; R₁, R₂, R₃, R₄, R₅, and R₆ are each independently an alkyl group having a formula CₙH₂ₙ₊₁, wherein n ranges from 0 to 20; R₇ is one selected from H, -OH, -COOH, and -NH₂; and R₈ is one selected from an alkyl group having a formula CₙH₂ₙ₊₁, wherein n ranges from 0 to 20 or an alkanol group having a formula CₙH₂ₙOH wherein n ranges from 0 to 20 and wherein the composition is substantially free of a water-soluble amine.

21. The composition of claim 18 further comprising a fluoride ion source.

22. A composition for removing residues from a substrate comprising copper, the composition comprising:
an organic polar solvent;
water;
a quaternary ammonium compound;
optionally hydroxylamine provided that a mass ratio of the hydroxylamine if present to quaternary ammonium compound is less than 3; and
a mercapto-containing corrosion inhibitor selected from the group consisting of a compound having a following formula (I), a compound having a following formula (II), 2-mercaptothiazoline, 3-mercaptopropyl-trimethoxysilane, and mixtures thereof 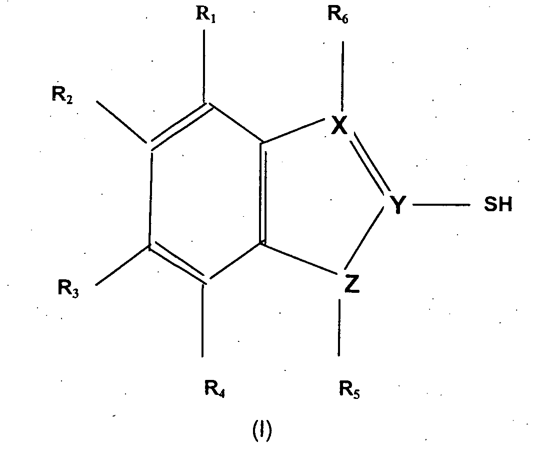 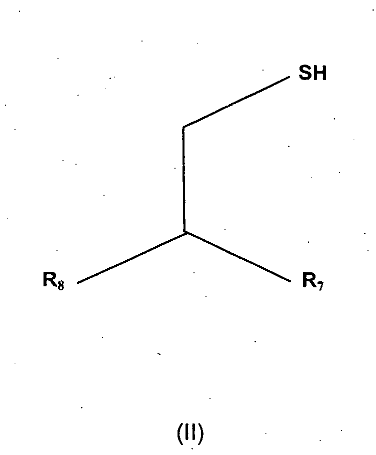
wherein X, Y, and Z are each independently selected from C, N, O, S, and P; R₁, R₂, R₃, R₄, R₅, and R₆ are each independently an alkyl group having a formula CₙH_{2n+1,} wherein n ranges from 0 to 20; R₇ is one selected from H, -OH, -COOH, and -NH₂; and R₈ is one selected from an alkyl group having a formula CₙH_{2n+1,} wherein n ranges from 0 to 20 or an alkanol group having a formula CₙH₂ₙOH wherein n ranges from 0 to 20; and
wherein the composition exhibits a copper etch rate that is less than 5 angstroms/minute.
